# EUROPEAN PATENT SPECIFICATION

(11) **EP 0 273 351 B1**
(45) Date of publication and mention of the grant of the patent: **05.05.1993**
(21) Application number: 87118954.4
(22) Date of filing: 21.12.1987
(51) Int. Cl.: H01J 37/305, G03F 1/00

(54) **Apparatus for repairing a pattern film**
Gerät zur Ausbesserung eines gemusterten Films
Appareil pour la réparation d'un film comportant des motifs

(30) Priority: 26.12.1986 JP 315263/86; 23.10.1987 JP 268678/87
(43) Date of publication of application: 06.07.1988
(73) Proprietor: SEIKO INSTRUMENTS INC., Tokyo 136 (JP)
(72) Inventor: Hattori, Osamu, Koto-ku Tokyo (JP); Yasaka, Anto, Koto-ku Tokyo (JP); Nakagawa, Yoshitomo, Koto-ku Tokyo (JP); Sato, Mitsuyoshi, Koto-ku Tokyo (JP); Sasaki, Sumio, Koto-ku Tokyo (JP)
(74) Representative: Grams, Klaus Dieter, Dipl.-Ing.

(56) References cited:
- WO-A-86/02774
- JOURNAL OF VACUUM SCIENCE & TECHNOLOGY/B, vol. 3, no. 1, second series, January/February 1985, pages 67-70, Woodbury, NY, US; Y. OCHIAI et al.: "Pressure and irradiation angle dependence of maskless ion beam assisted etching of GaAs and Si"

## Description

This invention relates to an apparatus for repairing a pattern film of a photomask, a reticle, semiconductor, etc.

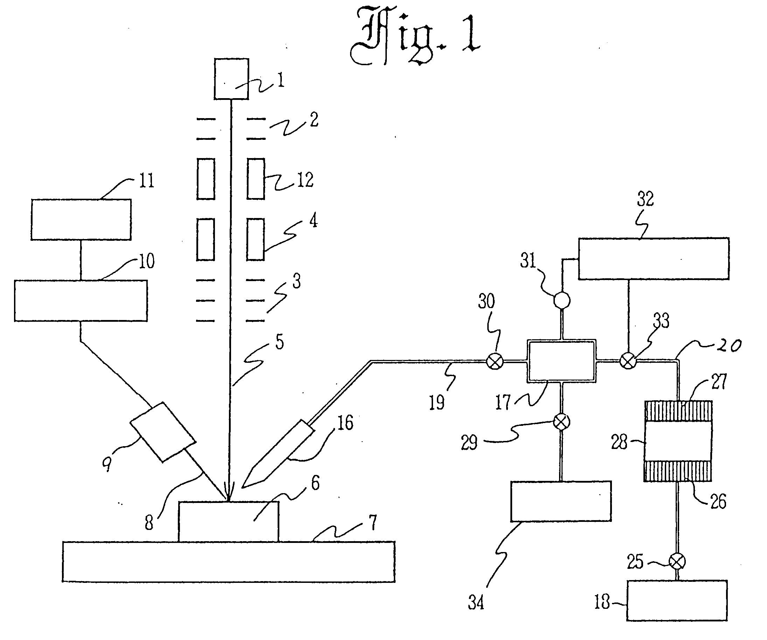

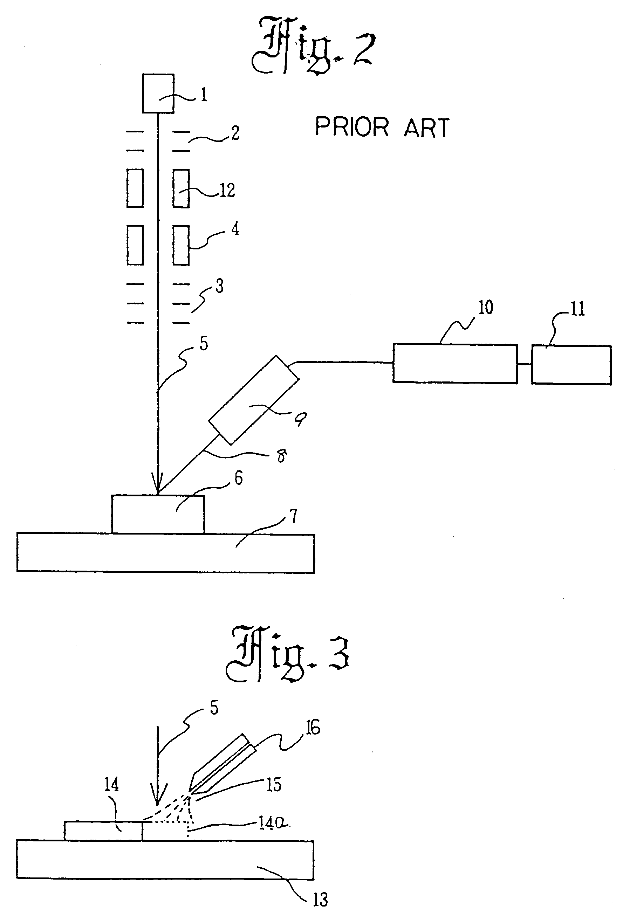

Fig. 2 shows a conventional apparatus for repairing a pattern film. Ions, which are generated from an ion source 1, pass through an ion optical system including a focusing lens 2 and an objective lens 3 and are formed into a focused ion beam 5 having a predetermined radius(of not more than 1 µm). The focused ion beam 5 passes through a scanning electrode 4 and scans across a surface of a sample 6.

An excess portion of a pattern film formed on the surface of the sample 6 is positioned directly below the focused ion beam by moving an XY stage 7 on a basis of preset data and/or secondary charged particles 8 emitted from the surface of the sample by the irradiation with the scanning focused ion beam 5 are detected by means of a secondary charged particle detector 9. The output from the secondary charged particle detector 9 pass through an electronic circuit such as A/D converter 10 so that a pattern of detected secondary charged particles 8 is displayed on a display device 11. The displayed pattern is observed and recognized by the naked eye, and then the sample 6 is moved by controlling the XY stage 7 so that the excess portion of the pattern film comes within the focused ion beam 5 scanning range.

The position and the range of the excess portion of the pattern film is defined by the display of the display device 11, and then the range of the excess portion of the pattern film is irradiated with the scanning focused ion beam by controlling the scanning electrode 4 and/or blanking electrode 12 (i.e.,deflecting the ion beam out of the sample so that it will not reach the sample). In this way, only the excess portion of the pattern is repeatedly irradiated with the scanning focused ion beam so that the pattern film in the predetermined excess portion is removed by means of sputtering (sputter etching) effected by ions.

The fact, that in the conventional photomask repairing apparatus a opaque defect is repaired (removed) by means of sputtering (sputter etching) with a scanning focused ion beam alone, causes following problems. When a opaque defect on a photomask was repaired by sputter etching alone, gallium remained on the surface of a substrate by irradiation of a scanning focused ion beam (gallium ions in most cases) and the transparence of a repaired portion of an opaque defect is reduced. And the repaired surface by means of sputter etching is not perfectly smooth so that it reflects light diffusively and the transparence of the repaired portion of an opaque defect is reduced. In addition to the above, when a pattern film is a multi-layered film of chrome and chrome oxide, on the boundary layer between a substrate and a chrome layer or a chrome oxide layer or a chrome layer and a chrome oxide layer changes the intensity of secondary charged particles so that it is difficult to judge when an opaque defect repair is completed. Because, this happens, an opaque defect repair may not be completed or unwanted damages on a substrate may be caused. So the reliability on opaque defect repair is not high. Further, the material of a pattern film formed on a substrate and subjected to sputter etching is sputter-deposited on the rise portion formed at the removed area of the pattern film or on the periphery thereof, which involves the problem that the sharpness of the sputter etched edge is degraded.

To overcome the above objections there is provided according to the invention, an apparatus for repairing a pattern film comprising an ion source for emitting ions, an ion lens system for forming said ions into a focused ion beam, a scanning electrode system adapted to irradiate a sample with a focused ion beam while scanning said sample with said focused ion beam, a secondary charged particle detector for detecting secondary particles emitted from the surface of said sample, an evacuation system for placing said ion source, said ion lens system, said scanning electrode system and secondary charged particle detector in vacuum, an image display device for displaying a pattern being formed on said sample surface on the basis of the planar intensity distribution of said secondary charged particles, and means for removing an excess portion of said pattern by selectively irradiating the excess portion of said pattern with the scanning focused ion beam repeatedly characterized by having a gas injector for providing a chemical etching gas to the excess portion of said pattern, said gas injector comprising a nozzle directing an etching gas against said excess portion. The excess portion may be an opaque defect of a photomask or reticle, or an excess portion of a pattern film of a semiconductor (IC, LSI etc.).

The invention is to obtain following results by irradiating a scanning focused ion beam and an etching gas onto an excess portion of a pattern film which is to be removed. When chloride is used as the etching gas, chlorine reacts with gallium ions in the irradiated ion beam and they form volatile gallium chloride so that no gallium remains on the sample, and in the photomask the transparence of the repaired portion of the opaque defect is improved. The etched surface becomes perfectly smooth (referred to as smooth surface etching hereinafter) by using an etching gas so that the reduction of the transparence caused by diffused light does not occur, since the etching gas assisted by ions reacts with the material of the excess portion of the pattern film and does not react with the substrate and the other portion of the pattern film which is not irradiated with the scanning focused ion beam. Further, when secondary ions emitted from the surface of the sample are detected by the secondary charged particle detector, without regard to whether a pattern film consists of a layered film or not, when any element to be detected exists, the secondary ion intensity of said element is stabilized at a high level by using an etching gas such as chlorine. So it becomes easier to judge when a repair is completed and the reliability on the repair of the pattern film is improved. Without deteriorating the vacuum condition, the excess portion of the pattern film can be steadily repaired by means of an etching gas applied only locally to the excess portion of the pattern film, while the supply of the etching gas is controlled.

The invention will now be described in greater detail with reference to the drawing.

Fig. 1 shows the general arrangement of the apparatus according to the present invention.

Fig. 2 shows the general arrangement of a prior art apparatus.

Fig. 3 is a sectional view for explaining an opaque defect repair.

Fig.4 is a supplemental drawing a control chamber.

Fig.5 is a partial supplemental drawing for explaining an embodiment of a gas injector using a permeator in a reservoir.

Fig. 6 is a sectional view for explaining a permeator.

Fig. 7 and Fig. 8 are the explanatory arrangement drawing of embodiments of exhausting the control chamber.

Fig. 9 is a partial supplemental drawing for explaining an embodiment of controlling the pressure in the control.

One embodiment of the present invention will be described hereunder in detail with reference to the drawings.

Fig.1 shows an apparatus for repairing a pattern film according to the present invention. Numeral 1 is an ion source generating ions. The ion source 1 is, for example, a liquid-metal gallium source in this embodiment. Ions generated from ion source 1 pass through an ion optical system including a focusing lens 2 and an objective lens 3 and are formed into a focused ion beam 5. Numeral 4 is a scanning electrode to which a scanning voltage is applied. The focused ion beam 5 irradiates a sample 6 while scanning across a surface of the sample 6 by passing through the scanning electrode 4. The sample 6 is, for example, a photomask, a reticle, an X-ray mask or a semiconductor such as IC and LSI. In this embodiment, the sample 6 is a photomask comprising a transparent substrate of glass and a chromium pattern film formed on the substrate. Secondary charged particles 8 are emitted from the surface of the sample 6 irradiated with the scanning focused ion beam 5. In this embodiment, the secondary charged particles are silicon ions of the substrate material or chromium ions of the pattern film material. However, the secondary charged particles 8 can also be secondary electrons. Numeral 9 is a secondary charged particle detector for detecting the secondary charged particles 8. The above system is placed by means of an evacuation system (not illustrated in the drawing) in vacuum condition in which the pressure is not more than 1,33.10⁻²Pa (10⁻⁴ Torr). Numeral 10 is an A/D converter for converting the secondary charged particle signals detected by means of the secondary charged particle detector 9. The output from the A/D converter 10 is displayed by means of an image display device 11. Patterns on the sample 6 can be displayed by synchronizing the scanning of the focused ion beam 5 with the display of the scan by means of the image display device 11. Numeral 7 is an XY stage in which the sample 6 is placed and is movable in X and Y directions. On the basis of preset position data, the XY stage 7 can be moved to the wanted position so that a repairing portion of the pattern film of the sample 6 comes within the focused ion beam scanning range. Numeral 12 is a blanking electrode. When unwanted damages on the sample 6 should not be caused by irradiating the surface of the sample 6 with the scanning focused ion beam 5, blanking voltage should be applied to the blanking electrode 12 so that the scanning focused ion beam 5 is deflected in order to not irradiate the surface of the sample 6.

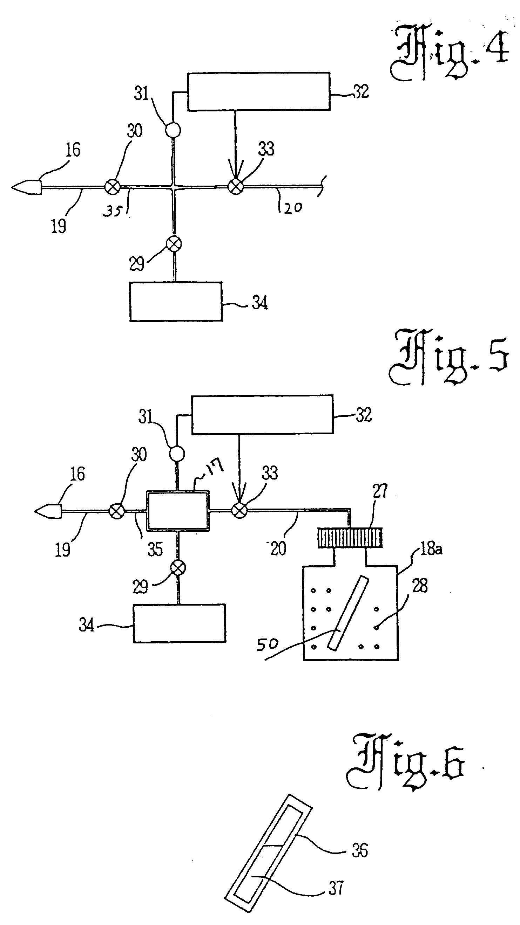

Fig. 3 is a sectional view of an example of a repairing an opaque defect of the photomask. The sample 6 comprises a glass substrate 13 and a pattern film 14 of chromium or molybdenum silicide having an excess portion 14a which is a so-called opaque defect. The pattern film 14 and the excess portion 14a of the film 14 are formed on the substrate 13. The excess portion 14a of the pattern film 14 is to be removed by means of the present apparatus. In repairing the opaque defect by removing the excess portion 14a, the range of scanning of the focused ion beam is set to the excess portion 14a and the scanning focused ion beam 5 is repeatedly irradiated only to the excess portion 14a of the pattern film 14. An etching gas 15, which is chlorine in this embodiment, is directed onto the excess portion 14a locally through a thin-tubed nozzle 16. The etching gas of chlorine has a smooth surface etching effect on the repaired portion of the opaque defect and an effect in which remains such as gallium are not left, since the etching gas reacts with gallium not to remain to the substrate 13. Further, the etching gas 15 at the excess portion, is activated by the focused ion beam 5 and reacts with the material of the excess portion film 14a. Then, the speed of removal of the material increases and the material is not deposited by sputtering around the excess portion 14a, since the material removed from the excess portion 14a reacts with the etching gas. While, the etching gas 15 outside of the excess portion 14a, which is not irradiated with focused ion beam 5, is not activated by focused ion beam 5, the etching gas 15 does not react with the material of the pattern film. The etching gas 15, even if activated by the focused ion beam 5 at the excess portion, does not react with the glass material 13. Therefore the removal of the excess portion film 14a is achieved clearly and completely. The excess portion 14a film is not only part of a photomask or an X-ray mask but can also be part of a semiconductor.

Chlorine has also an effect which increases the quantity of the secondary ions emitted from the surface of the sample 6 by irradiating with the ion beam so that it becomes easier to judge when the opaque defect repair is completed and so the reliability on the opaque defect repair is improved.

The explanation of the gas injector shown in Fig. 1 is given as follows. The gas injector in Fig. 1 comprises a nozzle 16 for directing the etching gas onto the excess portion, a control chamber, a reservoir 18, pipes 19 and 20, a regulator 25, filters 26 and 27, a desiccant 28, valves 29 and 30, a vacuum gauge 31, a pressure controller 32, a variable flow quantity valve 33 and vacuum pomp 34. The reservoir 18 is, for example, a gas cylinder filled with the chemical etching gas 15. When the reservoir 18 is the gas cylinder, the etching gas 15 flows into the pipe 20 through the regulator 25 for reducing the gas pressure of the gas flow from the regulator 25. The pipe 19 and 20 are, for example, stainless steel tubes of 0,6 cm (1/4 inch) diameter. The etching gas 15 flows out of the regulator 25 into the variable flow quantity valve 33 through the filters 26 and 27 and desiccant 28. The desiccant 28 is to remove water containing impurities in the etching gas 15 and water left on the inside of pipes 19 and 20. In case the etching gas contains water, water molecules adhere onto the portion of the opaque defect repair, when the opaque defect is being repaired, so that the etching process is disturbed with the adhered water molecules. The desiccant 28 must be chemically stable against the etching gas 15. When the desiccant 28 is not chemically stable against the etching gas 15 and the desiccant 28 reacts with the etching gas 15, impurities caused by reaction are mixed in the etching gas 15 as an impure gas so that it disturbs the process of the opaque defect repair. In case the etching gas 15 is chlorine, the desiccant 28 is, for example, magnesium perchlorate. It is no doubt that the sort of the desiccant 28 should be selected relatively to the sort of the etching gas 15.

The filters 26 and 27 consist of many pores for admitting only the etching gas 15 and for filtering dust. The filters 26 and 27 are to prevent the powder of desiccant 28 from reaching variable flow quantity valve 33 and the regulator 25 and from disturbing the functioning by blocking the variable flow quantity valve 33. The pressure of etching gas 15, which flows into the control chamber 17 through the variable flow quantity valve 33, is controlled in the control chamber 17. The etching gas 15 is directed through the valve 30 and the nozzle 16 onto the position to be irradiated with the scanning focused ion beam 5, that is, the position of the opaque defect to be repaired. Therefore, the pressure in the control chamber 17 is controlled as follows. The pressure in the control chamber 17 is detected with the vacuum gauge 31 connected with the control chamber 17. The pressure signals are transmitted from the vacuum gauge 31 to the pressure controller 32. On basis of the signals transmitted from the vacuum gauge 31, the pressure controller 32 calculated the difference between the pressure in the control chamber 17 and the predetermined pressure value and the variation of the pressure in the control chamber 17 per unit hour, then transmits to the variable flow quantity valve 33 the signal for keeping the pressure in the control chamber 17 at the predetermined pressure. The variable flow quantity valve 33 varies the conductance in response to the signals transmitted from the pressure controller 32 so that the quantity of the etching gas, which flows into the control chamber 17, is controlled. The purpose of controlling the pressure in the control chamber 17 is to control flow quantity of the etching gas 15, which is blown from the nozzle 16. When the flow quantity of the etching gas, which is blown from the nozzle 16, is small, the reaction between the etching gas 15 and the material of the pattern film or the ions can not be obtained sufficiently, while, when the flow quantity of the etching gas 15 from the nozzle 16 is big, the life of the ion source 1, the secondary charged particle detector 9, etc. becomes shorter. The optimum pressure in the control chamber 17 varies in response to factors such as the diameter or the length of the nozzle 16, but it is fixed between 0,13 and 26,6 Pa (1×10⁻³ and 2×10⁻¹ Torr), in repairing the opaque defect. Vacuum gauges, which are generally used, are, for example, of ionization or of thermocouple type, which are not suitable for measuring the pressure in the control chamber 17, when the etching gas is a corrosive gas such as chlorine. The ionization gauge or the thermocouple gauge heats a filament in the gauge itself so that the filament reacts with the etching gas 15 and changes according to a time lapse and becomes incapable of measuring precisely. Apart from that, the products generated by the reaction of the filament with the etching gas 15 disturb repairing the opaque defect since the gas is impure. So the gauge 31, to be used in this embodiment, must be of diaphragm type or of spinning rotor type. Since the diaphragm type vacuum gauge detects the pressure by detecting the displacement of a metal diaphragm having a high corrosive resistance, detected pressure value does not change according to a time lapse and the etching gas 15 causes no reaction which generates products. The spinning rotor type vacuum gauge detects the pressure by utilizing the fact that the variation of rotation speed of a steel ball rotating while floating magnetically is proportionate to the pressure in which the steel ball is placed. So a change of detected pressure value according to a time lapse and products caused by the etching gas 15 do not occur. The vacuum gauge 31 is, for example, a Baratron vacuum gauge of Japan MSK Co. Ltd. made.

The valve 30 is opened when the etching gas 15 is blown from the nozzle 16, and it is closed when the etching gas 15 is not necessary to be blown from the nozzle 16.

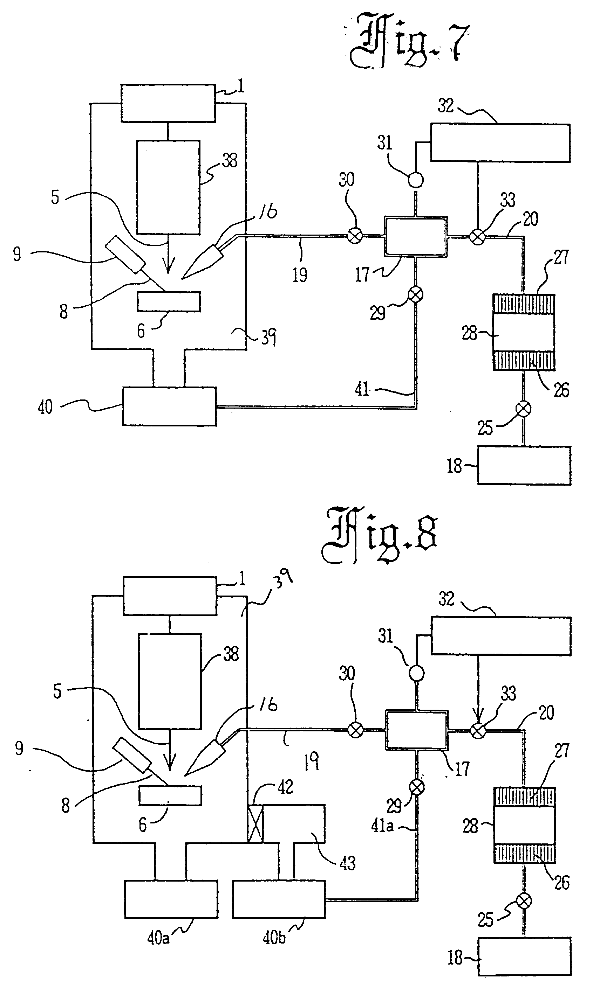

The vacuum pump 34 is to exhaust the air which flows into pipes while the reservoir is exchanged or installed and is to exhaust the gas emitted from the wall of the control chamber 17, etc. The control chamber 17 is exhausted by the vacuum pump 34 by means of opening or closing the valve 29 when necessary. The partial pressure of impurity gas in the control chamber 17 is kept at 1% or less than the partial pressure of etching gas 15. When the vacuum pump 34 is a rotary or oil diffusion pump, oil exhaled in the pump flows into the control chamber 17 as an impurity gas or reacts with the etching gas 15 and disturbs repairing the opaque defect. So the vacuum pump 34 must be a turbo-molecule, or cryo or mercury diffusion pump. The control chamber 17 in Fig. 1 is a particular chamber for controlling the inside pressure. In another embodiment shown in Fig. 4 the pressure of the pipe 35, which is equivalent to the pipes 19 and 20 in Fig. 1, is measured by means of the vacuum gauge 31. The flow quantity of the etching gas 15, which is blown from the nozzle 16, is controlled by controlling the pressure in the pipe 35. So the pipe 35 in Fig. 4 is equivalent to the control chamber 17 in Fig. 1.

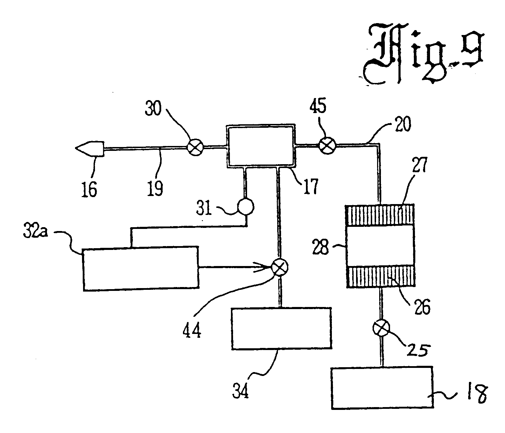

With reference to Fig.5 and Fig. 6, the explanation of another embodiment of a gas injector in that a permeator is used as the reservoir, is given as follows. Fig. 6 shows an example of a permeator 50. Numeral 36 is a cell. Numeral 37 is a concentrated etching gas. The concentrated etching material 37 is fluid chlorine in case the etching gas is chlorine. The cell 36 is made of a resin such as PTFE (polytetrafluoro ethylene). The enriched etching material 37 filled in the cell 36 permeates and diffuses in the resin and the etching gas is emitted from the surface of the cell 36. The permeators are on the market as permeation tubes or diffusion tubes made by Gastec Co. Ltd. Fig. 5 shows a gas injector in which the permeator 50 is used in a reservoir 18a. The reservoir 18a in Fig. 5 is a container in which a desiccant 28 and the permeator 50 are placed. The permeator 50 shown in Fig. 5 emits the etching gas 15, which is dried by the desiccant 28 in the reservoir 18a. The etching gas 15 emitted and dried in the reservoir 18a passes through the filter 27 with pores for filtering dust and reaches the variable flow quantity valve 33 through the pipe 20. Other parts of the gas injector are described with reference to Fig. 1. The operation of the gas injector and the flow quantity valve 33 are equivalent, to those in Fig. 1.

With reference to Fig. 7 and Fig. 8, the explanation of the evacuation system in a pattern film repairing apparatus of the present invention is given as follows. In Fig. 7, numeral 38 is an ion optical system, numeral 39 is a sample room, numeral 40 is an evacuation system and numeral 41 is a pipe. The ion optical system 38 comprises the focusing lens 2, the blanking electrode 12, the scanning electrode 4, the objective lens 3, etc. The sample room 39 is a vacuum chamber, in which the ion optical system 38, the secondary charged particle detector 8, the sample 6, etc., are placed. The evacuation system 40 is an apparatus for keeping the inside pressure of the sample room 39 at 0,013 Pa (1×10⁻⁴ Torr) or less. In the embodiment of the present invention with reference to Fig. 1, the position of the vacuum pump 34 is not mentioned. Since the vacuum pump 34 in Fig. 1 is independent of the evacuation system 40 in Fig. 7, the apparatus becomes larger and the production cost becomes more expensive. In this embodiment the control chamber 17 is exhausted by means of being connected to the evacuation system 40 through the valve 29 and the pipe 41 so that the size increase of the apparatus and the cost increase are kept to the minimum.

A further embodiment of exhaustion of the control chamber 17 in Fig. 8 is explained as follows. In Fig. 8, numeral 41a is a pipe, numeral 42 is a gate-valve and numeral 43 is an auxiliary chamber. The evacuation system 40a is an apparatus for keeping the inside pressure of the sample room 39 at 0,013 Pa (1×10⁻⁴ Torr) or less. The gate-valve 42 and the auxiliary chamber 43 are for introducing and taking out the sample 6 from the apparatus for repairing a pattern film, that is, in case the sample 6 is set in the apparatus, air is let in into the auxiliary chamber 43 so that the pressure in the auxiliary chamber 43 becomes atmospherical and the sample 6 can be inserted in the auxiliary chamber 43. Then the auxiliary chamber 43 is evacuated, the gate-valve 42 is opened and the sample 6 is moved to the predetermined position in the sample room 39. In case the sample 6 is taken out of the apparatus, above operation is carried out in the reverse order. The evacuation system 40b is an apparatus for evacuating the auxiliary chamber 43. In the embodiment of the invention with reference to Fig. 8, the necessary exhaust of the control chamber 17 is obtained, by means of exhausting the control chamber 17 through the valve 29 and the pipe 41a, wherein the size increase of the apparatus and the cost increase are kept to the minimum. In the embodiment with reference to Fig. 8, the gate-valve 42 is closed, when the air is let in into the auxiliary chamber 43.

With reference to Fig.9, the explanation of another embodiment of the invention is given as follows, in which the pressure of the etching gas in the control chamber 17 is controlled by means of fixing the supply of the etching gas which flows into control chamber 17 while the speed of exhausting the control chamber 17 is variable. In fig. 9 numeral 32a is a pressure controller, numeral 44 is a variable flow quantity valve and numeral 45 is a conductance valve. With reference to Fig. 9, the pressure in the control chamber 17 is controlled as follows. The quantity of the etching gas flow into the control chamber 17 is controlled, through the conductance valve 45 which has a fixed conductance, in response to the pressure of the conductance valve 45 of the reservoir's side. The pressure in the control chamber 17 is detected with the vacuum gauge 31 provided in the control chamber 17 and the pressure signals are transmitted from the vacuum gauge 31 to the pressure controller 32a. On basis of the pressure signals transmitted from the vacuum gauge 31, the pressure controller 32a calculates the difference between the pressure in the control chamber 17 and the predetermined pressure value and the variation of the pressure in the control chamber 17 per unit hour, then transmits to the variable flow quantity valve 44 signals for keeping the pressure in the control chamber 17 at the predetermined pressure. The variable flow quantity valve 44 varies the conductance relative to the signals transmitted from the pressure controller 32a so that the speed of exhausting the control chamber 17 is controlled. In this way the pressure in the control chamber 17 is controlled by means of balancing the quantity of the etching gas which flows into the control chamber 17. In the embodiment with reference to Fig. 9, the reservoir 18 is a gas cylinder. In case the permeator shown in Fig. 5 and Fig. 6 is used in the reservoir, the same effect can be obtained in the present embodiment.

When the sample comprises other materials, the etching gas used is another suitable gas, for example a carbon tetrachlorine, a mixture gas of carbon tetrachlorine and oxygen, etc.

The present invention is to obtain following effects by means of irradiating a scanning focused ion beam and directing an etching gas to the excess portion of the pattern film, when the excess portion of the pattern film is removed. When chlorine is used as the etching gas, chlorine reacts with gallium irradiated by the ion beam, and then volatile gallum chloride is generated so that gallium does not remain on the substrate on which the pattern film is formed. The etching gas assisted by the ion beam reacts with the material of the pattern film, and then the material which is removed from the substrate does not deposit at the fringe of the excess portion by sputter-deposition. Therefore, when the sample is the photomask, reticle or X-raymask, the repaired area has a high transparence.

By using a chemical etching gas, the etched surface becomes perfectly smooth (to be called smooth etching in the following) so that reduction of the transparence caused by diffused light does not occur.

By using a chemical etching gas, when secondary charged particles emitted from the sample surface are detected by means of a secondary charged particle detector, without regard to whether a pattern film has a layered film or not, when any element to be detected exists, the secondary ion intensity of the element is stabilized at a high level. So it becomes easier to judge when a removal of the excess portion of the pattern film is completed and the reliability on the removal is improved.

Without deteriorating the vacuum condition, the excess portion of the pattern film can be steadily repaired by means of providing an etching gas locally to the excess portion of the pattern film.

By means of providing filters and a desiccant in a gas injector and exhausting a control chamber by a turbo-molecule pump, etc., a pure etching gas free of impurities can be supplied so that an excess portion of a pattern film can be repaired without being polluted by imputities.

By using a diaphragm type gauge as a vacuum gauge for detecting the pressure in the control chamber, the supply of the etching gas can be precisely controlled without damaging the vacuum gauge with the etching gas and without changing the quality of the etching gas with the vacuum gauge. The present invention relates to an apparatus for repairing a pattern film of a photomask, reticle, X-ray mask, semiconductor, etc. In the apparatus, a focused ion beam is applied to an excess portion of a pattern film which is formed on a substrate. The excess portion of the pattern film is removed by means of ion sputtering. For repairing excess portion of the pattern film, a chemical etching gas is provided to a position that is being irradiated with the scanning focused ion beam thereby increasing the reliability on repairing and carrying out the repair of the excess portion of the pattern film with good quality. Further, the removal speed of the excess portion film is high.

## Claims

1. An apparatus for repairing a pattern film comprising an ion source for emitting ions, an ion lens system for forming said ions into a focused ion beam, a scanning electrode system adapted to irradiate a sample with said ion beam while scanning said sample with said ion beam, a secondary charged particle detector for detecting secondary particles emitted from the surface of said sample, an evacuation system for placing said ion source, said ion lens system, said scanning electrode system and secondary charged particle detector in vacuum, an image display device for displaying a pattern of a pattern film being formed on the sample surface on the basis of the planar intensity distribution of the secondary charged particles, and means for removing an excess portion of said pattern film by selectively irradiating the excess portion of said pattern film with the scanning focused ion beam repeatedly,
characterized by having a gas injector for providing a chemical etching gas to the ex cell portion of said pattern, said gas injector comprising a nozzle directing the etching gas against said excess portion.

2. An apparatus for repairing a pattern film as claimed in claim 1, wherein said sample is a photomask for producing a semiconductor.

3. An apparatus for repairing a pattern film as claimed in claim 1, wherein said sample is a reticle.

4. An apparatus for repairing a pattern film as claimed in claim 1, wherein said sample is a X-ray mask.

5. An apparatus for repairing a pattern film as claimed in claim 1, wherein said sample is a semiconductor.

6. An apparatus for repairing a pattern film as claimed in claim 2, wherein the substrate of said photomask is glass, and said pattern film is a chrome film.

7. An apparatus for repairing a pattern film as claimed in claim 2, wherein the substrate of said photomask is glass, and said pattern film is a molybdenum film.

8. An apparatus for repairing a pattern film as claimed in claim 1, wherein said etching gas is a chlorine.

9. An apparatus for repairing a pattern film as claimed in claim 1, wherein said etching gas is a carbon tetrachloride.

10. An apparatus for repairing a pattern film as claimed in claim 1, wherein said etching gas is a mixture of carbon tetrachloride and oxygen.

## Patentansprüche

1. Gerät zum Ausbessern eines mit einem Muster versehenen Films mit einer Ionenquelle zum Emittieren von Ionen, einem Ionenlinsensystem, das die Ionen zu einem fokussierten Ionenstrahl formt, einem Rasterelektrodensystem, das dazu gestaltet ist, eine Probe mit dem Ionenstrahl zu bestrahlen, während die Probe mit dem Ionenstrahl abgetastet wird, einem Detektor für geladene Sekundärteilchen zum Erfassen von von der Oberfläche der Probe emittierten Sekundärteilchen, einem Evakuierungssystem, um die Ionenquelle, das Ionenlinsensystem, das Rasterelektrodensystem und den Detektor für geladene Sekundärteilchen in Vakuum zu bringen, einem Bildanzeigegerät, um eine Struktur eines auf der Probenoberfläche gebildeten Films auf der Grundlage der ebenen Intensitätsverteilung der geladenen Sekundärteilchen darzustellen, und einer Vorrichtung zum Entfernen eines überstehenden Abschnittes des Films, indem der überstehende Abschnitt des Films wiederholt mit dem fokussierten Rasterionenstrahl selektiv bestrahlt wird,
gekennzeichnet durch einen Gasstrahler zum Anwenden eines chemischen Ätzgases auf den überstehenden Teil der Struktur, wobei der Gasstrahler eine Düse aufweist, die das Ätzgas auf den überstehenden Abschnitt leitet.

2. Gerät zum Ausbessern eines mit einem Muster versehenen Films nach Anspruch 1, wobei die Probe eine Photomaske zur Herstellung eines Halbleiters ist.

3. Gerät zum Ausbessern eines mit einem Muster versehenen Films nach Anspruch 1, wobei die Probe ein Gitternetz ist.

4. Gerät zum Ausbessern eines mit einem Muster versehenen Films nach Anspruch 1, wobei die Probe eine Röntgenmaske ist.

5. Gerät zum Ausbessern eines mit einem Muster versehenen Films nach Anspruch 1, wobei die Probe ein Halbleiter ist.

6. Gerät zum Ausbessern eines mit einem Muster versehenen Films nach Anspruch 2, wobei das Substrat der Photomaske Glas ist, und der Film ein Chrom-Film ist.

7. Gerät zum Ausbessern eines mit einem Muster versehenen Films nach Anspruch 2, wobei das Substrat der Photomaske Glas ist und der Film ein Molybdän-Film ist.

8. Gerät zum Ausbessern eines mit einem Muster versehenen Films nach Anspruch 1, wobei das Ätzgas Chlor ist.

9. Gerät zum Ausbessern eines mit einem Muster versehenen Films nach Anspruch 1, wobei das Ätzgas Tetrachlorkohlenstoff ist.

10. Gerät zum Ausbessern eines mit einem Muster versehenen Films nach Anspruch 1, wobei das Ätzgas ein Gemisch aus Tetrachlorkohlenstoff und Sauerstoff ist.

## Revendications

1. Appareil de réparation d'un film à motif, comprenant une source destinée à émettre des ions, un ensemble à lentille ionique destiné à mettre les ions sous forme d'un faisceau ionique focalisé, un ensemble à électrode de balayage destiné à irradier un échantillon à l'aide du faisceau ionique avec balayage de l'échantillon par le faisceau ionique, un détecteur de particules secondaires chargées destiné à détecter les particules secondaires émises par la surface de l'échantillon, un ensemble d'évacuation destiné à mettre sous vide la source ionique, l'ensemble à lentille, l'ensemble à électrode de balayage et le détecteur des particules secondaires chargées, un dispositif d'affichage d'image destiné à afficher un motif d'un film à motif formé à la surface de l'échantillon en fonction de la distribution plane d'intensité des particules secondaires chargées, et un dispositif destiné à retirer toute partie en excès du film à motif par irradiation sélective de cette partie en excès du film à motif par le faisceau ionique focalisé de balayage de manière répétée,
caractérisé en ce qu'il comporte un injecteur de gaz destiné à transmettre un gaz d'attaque chimique à la partie en excès du film à motif, l'injecteur de gaz comprenant une buse qui dirige le gaz d'attaque sur la partie en excès.

2. Appareil de réparation d'un film à motif selon la revendication 1, dans lequel l'échantillon est un masque photographique destiné à la production d'un semi-conducteur.

3. Appareil de réparation d'un film à motif selon la revendication 1, dans lequel l'échantillon est un réticule.

4. Appareil de réparation d'un film à motif selon la revendication 1, dans lequel l'échantillon est un masque radiographique.

5. Appareil de réparation d'un film à motif selon la revendication 1, dans lequel l'échantillon est un semi-conducteur.

6. Appareil de réparation d'un film à motif selon la revendication 2, dans lequel le substrat du masque photographique est le verre, et le film à motif est un film de chrome.

7. Appareil de réparation d'un film à motif selon la revendication 2, dans lequel le substrat du masque photographique est du verre, et le film à motif est un film de molybdène.

8. Appareil de réparation d'un film à motif selon la revendication 1, dans lequel le gaz d'attaque est le chlore.

9. Appareil de réparation d'un film à motif selon la revendication 1, dans lequel le gaz d'attaque est le tétrachlorure de carbone.

10. Appareil de réparation d'un film à motif selon la revendication 1, dans lequel le gaz d'attaque est un mélange de tétrachlorure de carbone et d'oxygène.
